# EUROPEAN PATENT APPLICATION

(11) **EP 2 431 771 A2**
(43) Date of publication of application: **21.03.2012**
(21) Application number: 10714043.6
(22) Date of filing: 11.03.2010
(51) Int. Cl.: G02B 1/10, G02B 5/22

(54) **POLYMER LENS COMPRISING A HARDENING LAYER, AN ABSORBENT LAYER, AND AN INTERFERENTIAL MULTILAYER, AND CORRESPONDING PRODUCTION METHOD**

(30) Priority: 20.03.2009 ES 200900753
(71) Applicant: Indo Internacional, S.A., 08174 Sant Cugat del Vallès Barcelona (ES)
(72) Inventor: FERNÁNDEZ SERRANO, Ricardo, 28040 Madrid (ES); VILAJOANA MAS, Ántoni, E-08302-Mataró (Barcelona) (ES); DÜRSTELER LÓPEZ, Juan Carlos, E-08860-Castelldefels Barcelona (ES); GIL ROSTRA, Jorge, E-41092-Sevilla (ES); YUBERO VALENCIA, Francisco, E-41092-Sevilla (ES); RODRÍGUEZ GONZÁLEZ-ELIPE, Agustín, E-41092-Sevilla (ES)
(74) Representative: Curell Suñol, Marcelino
(86) International application number: PCT/ES2010/000100
(87) International publication number: WO 2010/106200

(57) **Abstract**

Polymer based lens comprising a hardening layer, an absorbent layer and interferential multi-layer and corresponding manufacturing method. Polymer based lens comprising a hardening layer (L), an interferential multi-layer (I) and an absorbent layer (A) sandwiched between both. The absorbent layer (A) is made from a metal, metal oxide or metal nitride, suitable for producing a transparent layer via deposition by sputtering, and in addition comprises, cations of a colouring metal from the group made up of those transition elements which, in oxided form, have a cation that absorbs electromagnetic radiation in the visible spectrum. The cations of the colouring metal are in a proportion between 10% and 70% atomic percentage of the cations with respect to the cation of the predominant metal in said absorbent layer (A).

## Description

### Field of the invention

The invention relates to a polymer based lens, comprising a hardening layer and an interferential multi-layer, where the hardening layer is at least 500 nm (nanometres) thick, and the interferential multi-layer is made up of a plurality of sublayers where the thickness of each of said sublayers is less than 250 nm. The invention also relates to some manufacturing methods of said lens.

### State of the art

The technique of colouring polymeric lenses using immersion techniques in distilled water baths is well known, where the pigments are dissolved or dispersed at temperatures around 100ºC, usually in the range of between 90ºC and 98ºC. A bath is used with a pre-established mixture of pigments to achieve the desired colour. Once the suitable pigments are dissolved or in suspension in the distilled water bath, the lenses are introduced for a certain time according to the desired tone. The longer the immersion time, the darker the tone obtained. The colour is obtained by introducing the pigments into the polymer base of the lens. This system is widely implemented on an industrial level and a large diversity of colours can be obtained. However, obtaining the desired colour through this system sometimes requires a final adjustment using baths containing the three pure primary colours (yellow, red and blue), based on trial and error immersion times in each bath. In short, the system depends largely on the experience of the operator and it is highly irreproducible, which is a serious problem, particularly considering that lenses are made in pairs.

Sometimes a previous activation process is carried out to accelerate the lens colouring process, and this consists in immersing the lenses in a deionised water bath containing 10% benzyl alcohol and also 10% surfactants. The bath is between 92ºC and 96ºC, and the immersion times range from 30 to 60 seconds, depending on the state of the colour bath.

Usually these coloured lenses are then lacquered (in other words, a hardening layer is added) and thermally cured before being coated with an interferential multi-layer which, suitably sized, can generate an anti-reflectant AR stack, in the high vacuum machines.

With polymeric based lenses it is also possible to use a coating process using high vacuum PVD depositing techniques with a resistive evaporator or electron gun. In order to apply this method, the material to be evaporated is placed in melting pots arranged for this purpose, and the evaporation takes place under suitable conditions to produce the coloured layer on the lens. The use of this technique is limited by the evaporation materials available on the market. Generally, it is a complex, fairly inflexible technique, and therefore only very specific colours are available on the market, which are obtained from very specific compositions. More specifically, the inventors only know of the following cases:
- grey colour, obtained from a layer of TiO2 including Si cations, where the Si cations are in a proportion ranging between 11.5% and 16.5% atomic percentage of the cations in the layer.
- pink colour, obtained from a layer of SiO2 including Mn cations, where the Mn cations are in a proportion ranging between 37.5% and 42.5% atomic percentage of the cations in the layer.
- brown colour, obtained from a layer of SiO2 including Cr cations, where the Cr cations are in a proportion ranging between 47.5% and 52.5% atomic percentage of the cations in the layer; in fact, this colour can also be understood to be obtained from a layer of Cr2O3 including Si cations, where the Si cations are in a proportion ranging between 47.5% and 52.5% atomic percentage of the cations.

As already mentioned, it is known to coat polymeric lenses with a stack of layers having an anti-reflectant (or interferential) function, which makes it possible to reduce the amount of visible light reflected by the lens, or with an interferential stack, which works as a mirror, making it possible to reflect said visible light. To obtain these results, usually a stack of between 4 and 6 layers is made, each one between 10 nm and 150 nm thick. This is usually done using PVD (Physical Vapor Deposition) techniques, using an electron gun or thermal evaporation, although other techniques exist such as Plasma enhanced Chemical Vapor Deposition (PeCVD) or Sputtering.

Moreover, when depositing materials whose intrinsic thickness and characteristics introduce very high residual tensions to the structure, it is well known that problems arise regarding the degree to which these coatings adhere to the polymeric substrates. Equally, it is also known that by introducing, into the multi-layer coating structure of organic lenses, some layers on which some volatile precursor of a metal has been introduced, such as for example HMDSO (silicon volatile precursor), during the reactive sputtering process of silicon in the presence of oxygen, some layers are produced that are flexible enough to adhere well to the complete multi-layer structure. See, for example, patent applications EP 1.655.385 and ES P200800387.

Coating lenses, and particularly ophthalmic lenses, made from a polymer or having an organic nature, with hardening layers so as to improve their abrasion resistance, is carried out because the scratch resistance of this type of polymeric lenses is much more reduced than that of mineral lenses. This hardening coating (lacquer) is usually applied by immersion in a (poly)siloxanic, acryllic, metacryllic or polyuretanic bath and then curing in an oven at a temperature of between 100ºC and 130ºC. With this method, hardening layers are obtained that are about 1 and 3 microns thick. Another possible technique for producing the hardening coating is by applying lacquers using the spinning technique and curing them with ultraviolet radiation, which produces mechanical characteristics similar to those above, but with a productive process that only covers one face of the lens in each stage.

In this description and claims, it must be understood that lens means any optical system made up of at least one surface and which has dioptric and/or catoptric properties. In other words, any optical system based on refraction phenomena (dioptric systems) or reflection phenomena (catoptric systems). Also, those optical systems combing both effects must be considered lenses, such as for example optical systems with a first refractant surface and a second reflectant surface, optical systems with semi-transparent surfaces, etc.

### Disclosure of the invention

The aim of the invention is a new polymer based coloured lens. In particular, a polymer based lens comprising a hardening layer and an interferential multi-layer, where the hardening layer is at least 500 nm thick, and the interferential multi-layer is made up of a plurality of sublayers where each sublayer is less than 250 nm thick, **characterized in that** it comprises, in addition, an absorbent layer sandwiched between the hardening layer and the interferential multi-layer, where the absorbent layer is between 10 nm and 1500 nm thick and it is made from a material from the group made up of those metals, metal oxides and metal nitrides that are suitable for producing a transparent layer within the visible spectrum via deposition by sputtering, where the absorbent layer comprises, in addition, cations of a colouring metal from the group made up of those transition elements which, in oxided form, have a cation that absorbs electromagnetic radiation in the visible spectrum (in other words, between 400 and 750 nm (nanometres)), where the colouring metal cations are in a proportion between 10% and 70% atomic percentage of the cations with respect to the predominant cation of the metal in the absorbent layer (A), except : [i] in the case where the absorbent layer is made from TiO2 and the colouring metal cations are Si cations, where the Si cations are in a proportion between 11.5% and 16.5% atomic percentage of the cations, [ii] in the case where the absorbent layer is made from SiO2 and the colouring metal cations are Mn cations, where the Mn cations are in a proportion between 37.5% y and 42.5% atomic percentage of the cations, [iii] in the case where the absorbent layer is made from SiO2 and the colouring metal cations are Cr cations, where the Cr cations are in a proportion between 47.5% and 52.5% atomic percentage of the cations, and [iv] in the case where the absorbent layer is made from Cr2O3 and the colouring metal cations are Si cations, where the Si cations are in a proportion between 47.5% and 52.5% atomic percentage of the cations.

Throughout this description and claims, the % of colouring metal cations are always with respect to the predominant metallic cation in the absorbent layer.

In fact, the lenses according the invention have some layers, particularly one absorbent layer, with a very precisely determined thickness. In addition, they have a colouring metal content that is also very precise. This makes it possible to obtain a wide range of colours, and to easily reproduce a certain result.

Generally, obtaining a colouring layer means forming mixed oxides or nitrides of two (or more) metallic cations. They are usually complex compounds, with complex molar proportions, for example of the SiₓTi_{y}O_{z} type, where x, y and z can have different values. Usually there is a predominant cation and another one in a smaller proportion, although both can contribute to the final colouring. Therefore, in this description and claims the absorbent layer is defined as being made from "a material" (from the group made up of those metals, metal oxides and metal nitrides that are suitable for producing a transparent layer in the visible spectrum using deposition by sputtering) and from "colouring metal cations", without specifying in detail the particular structure that is formed during the deposition process. As an additional characteristic, the atomic % is indicated between the atoms (particularly the cations) of the colouring metal and the atoms (cations) of the predominant metal in the absorbent layer. That is, a relation is indicated (in %) between the metallic atoms of the colouring metal and the metallic atoms of the predominant metal in the absorbent layer.

As already mentioned, this invention excludes the three particular known cases of lenses produced using high vacuum PVD deposition techniques with a resistive evaporator or electron gun. Generally, it must be understood that all those particular cases of lenses made using high vacuum PVD deposition techniques using a resistive evaporator or electron gun are excluded from this invention.

Preferably the material in the group made up of : metals, metal oxides and metal nitrides suitable for producing a transparent layer in the visible spectrum via sputtering deposition is a material from the group made up of : metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic ytrium, Y₂O₃, magnesium, MgO, carbon, praseodimium, PrO₂, Pr₂O₃, tungsten, WO₃, silicon nitrides, silicon oxynitrides, and mixtures of the above.

Advantageously the colouring metal is a metal from the group made up of Ni, Cu, Fe, Cr, V, W, Co, Mn, Si and mixtures of the above.

Preferably the absorbent layer has visible transmittance between 4% and 85%, measured according to the ISO 8980/3 (2003) standard.

Advantageously the absorbent layer comprises a plurality of different colouring metal cations, because this way virtually any colouring can be obtained, thanks to the sum of the effects of each cation.

The lens according to the invention can comprises a plurality of absorbent layers, thus distributing the desired effect over them all. In fact, it must be taken into account that the lenses can have a plurality of layers that carry out certain functions (see document ES P200800387, cited above, particularly page. 4 lin. 22 to page 10 lin. 3). It is possible to avail of some or several of these layers to add the colouring cations to them. In this respect, it is possible that there are several layers with the same colouring cations (whereby the thicknesses of the layers in question in terms of the colouring effect, are "added together" ) and it is also possible that at least one of the absorbent layers has cations of a different colouring metal than the other absorbent layers, in which case the colouring effects of each layer would be combined.

Preferably the absorbent layer is between 100 nm and 600 nm thick and it is particularly advantageous that it is more than 300 nm thick. In fact, in this last case, the absorbent layer can, at the same time, have the function of the layer which in document ES P200800387 (page. 4 lin. 22 to page 5 lin. 14) is called the hard layer.

Advantageously the lens according to the invention comprises, in addition, a hard layer sandwiched between the hardening layer and the absorbent layer, where the hard layer is more than 300 nm thick and is made from a material from the group made up of : metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic ytrium, Y₂O₃, magnesium, MgO, carbon, praseodimium, PrO₂, Pr₂O₃, tungsten, WO₃, silicon nitrides, and silicon oxynitrides, where the absorbent layer can be obtained by polymerising the volatile precursors of metals in the silicon family, zirconium family, titanium family and tantalum family, by means of a PECVD and/or sputtering method. In this case, the absorbent layer can, at the same time, have the function of the layer which in document ES P200800387 (page 5 lin. 16 to page 6 lin. 9) is called the flexible layer. In fact, as can be seen, the colouring layer can, at the same time, have the function of another one (or other ones) of the layers in the lens (as defined in document ES P200800387, page 5 lin 1 to page 7 lin. 26): the function of the hard layer, the flexible layer and even of some of the interferential layers (particularly those comprising SiO2). Preferably the colouring layer has, simultaneously, the function of the flexible layer.

The aim of the invention is also a method for manufacturing a polymer based lens according to the invention, **characterized in that** it comprises a stage [a] of forming the hardening layer, a stage [b] of forming the absorbent layer, and a stage [c] of forming the interferential multi-layer, where stage [b] is carried out by sputtering material from the group made up of those metals, metal oxides and metal nitrides that are suitable for producing a transparent layer in the visible spectrum via deposition by sputtering, and the colouring metal cations from the group made up of those transition elements which, in oxided form, have a cation that absorbs electromagnetic radiation in the visible spectrum. In fact, this method is much more versatile and easier to apply than the high vacuum PVD deposition techniques with a resistive evaporator or electron gun. A great variety of colours and transmittances can be obtained, and the materials needed for the method are more easily obtainable. The desired thicknesses can be obtained very accurately, and the compositions (the % of added cation) can also be obtained very accurately. All this implies a great reduction in the dispersion of the results obtained.

Preferably, the sputtering stage [b] is carried out in an atmosphere comprising at least one of the components from the group made up of 02, N2, Ar, volatile precursors of metals in the silicon family, zirconium family, titanium family and tantalum family. Therefore, in this stage the volatile precursor of the metal is polymerised, while simultaneously carrying out a sputtering method and a PeCVD radio frequency method, where the sputtering is in an inert gas atmosphere, preferably argon, in the presence of oxygen, and in said PeCVD radio frequency plasma is used and the volatile precursor of the metal is injected.

Advantageously the method comprises a stage [b2] of forming a second absorbent layer.

Preferably sputtering stage [b] comprises using an Si cathode where its surface has been partially coated with a sheet of one of the colouring metals. Advantageously between 3% and 15% of the cathode surface has been coated with the sheet. As can be seen, this is an extremely simple way of preparing the starting materials, it can be done easily with any colouring metal and guarantees that the results obtained are very similar, thereby reducing the dispersion of results.

If it is desired that one absorbent layer has a mixture of more than one colouring metal, the cathode surface can be partially coated with at least a second sheet of a second colouring metal.

Alternatively, or in combination with the metals mentioned above, in the sputtering stage [b] a cathode comprising Si with one of the colouring metals can be used, or it can even comprise a second colouring metal.

Another advantageous possibility consists in using various cathodes in sputtering stage [b], where at least one of them comprises one of the colouring metals, in a simultaneous deposition process. Also, some of the cathodes can comprise a second colouring metal.

Advantageously the interferential multi-layer comprises a plurality of layers or sublayers, preferably between 4 and 6 layers, where each layer is between 10 nm and 220 nm thick and is made from the materials in the group made up of: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic ytrium, Y₂O₃, magnesium, MgO, carbon, praseodimium, PrO₂, Pr₂O₃, tungsten, WO₃, silicon nitrides, and silicon oxynitrides.

Preferably the hardening layer has a polysiloxanic, acryllic, metacryllic or polyuretanic base.

Advantageously the lens according to the invention has a final hydrophobic layer, preferably perfluorated and between 5 nm and 40 nm thick.

Preferably stage [a] is a sputtering stage in an inert gas atmosphere, preferably argon, in the alternate presence of oxygen or nitrogen and at electric powers between 100 W and 2500 W, giving rise to voltages between 100 V and 1000 V.

Advantageously the method comprises a stage [d] of producing a final hydrophobic layer, where stage [d] takes place after stage [c].

### Brief description of the drawings

Other advantages and characteristics of the invention will be appreciated from the following description, wherein, in a non-limiting manner, some preferable embodiments of the invention are described, with reference to the accompanying drawings, wherein:
Figs. 1 and 2, a schematic view of a cross-section of the layers arranged on the polymeric substrate of the lens according to two embodiments of the invention.
Figs. 3A and 3B, a schematic front and side view, respectively, of a cathode of a sputtering machine according to the invention, with some metallic strips placed on the cathode.

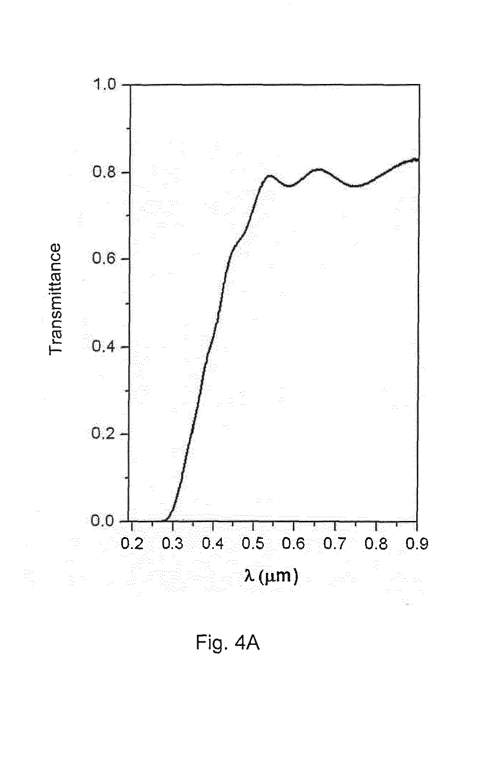

Fig. 4A, transmittance spectrum in the visible range of the sample described in the embodiment of the green lens with colormetric co-ordinates (0.331, 0.358, 0.311) according to CIE (x, y, z) 1931 on a previously lacquered MR7 lens. Also the colour co-ordinates are included.

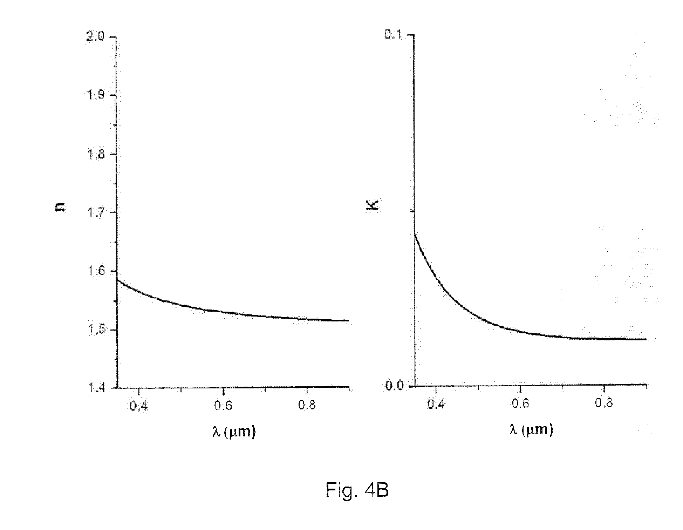

Fig. 4B, evolution of the real (n) and imaginary (k) part of the refraction index of the sample described in the embodiment of the green lens with colourmetric co-ordinates (0.331, 0.358, 0.311) according to CIE (x, y, z) 1931 on a previously lacquered MR7 lens.

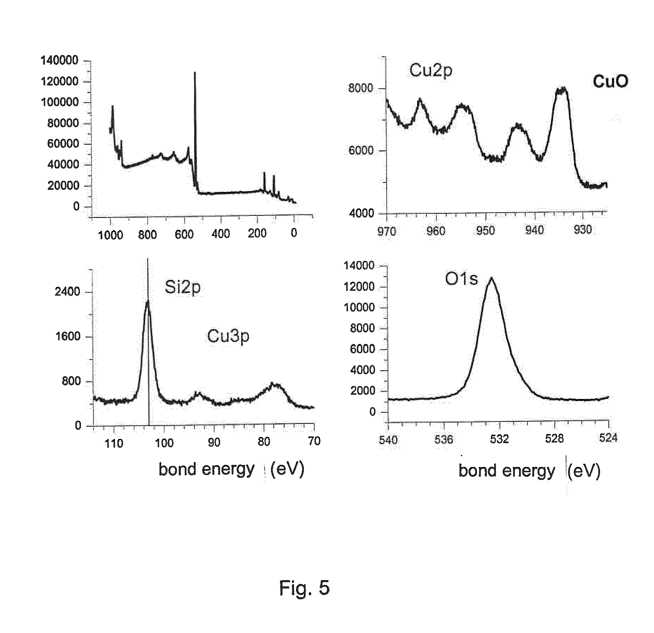

Fig. 5, general XPS spectrum and of the Cu2p, Si2p, Cu3p, O1s levels of the sample described in the embodiment of the green lens with colourmetric co-ordinates (0.331, 0.358, 0.311) according to CIE (x, y, z) 1931 on a previously lacquered MR7 lens and coated with an anti-reflectant multi-layer.

### Detailed description of some embodiments of the invention

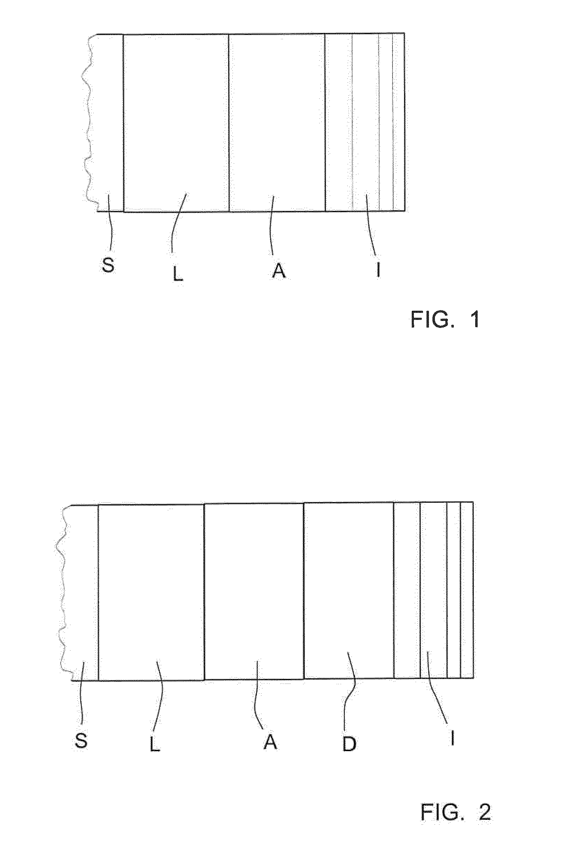

Fig. 1 shows the basic embodiment of the invention. The starting point consists of a polymer based lens that has a polymeric substrate S on which a hardening layer L has been deposited. On hardening layer L, an absorbent layer A has been deposited, and on absorbent layer A, an interferential multi-layer I has been deposited.

As already mentioned, the absorbent layer can, in addition to its own absorbent (colourant) function, have another function. For example, as described in document ES P200800387 (page 10 lin. 30 to page 11 lin. 12 and page 12 lin. 19 to page 13 lin. 4), it can have the function of what in said document is called the hard layer D.

Fig. 2 shows the case where a hard layer D has been added between the interferential multi-layer I and the absorbent layer A. In this case, and following the description in document ES P200800387 (page 10 lin. 30 to page 11 lin. 12 and page 12 lin. 8 to lin 17), the absorbent layer can have the function of what in said document is called the flexible layer F

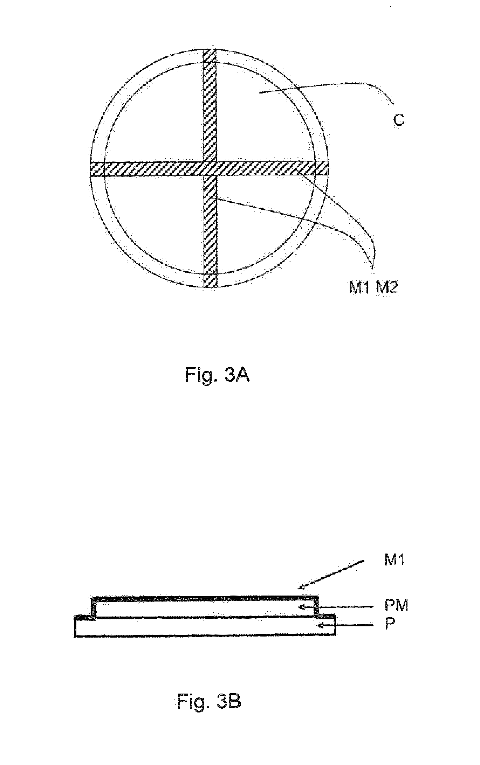

Fig. 3A shows a cathode C, for example a Si cathode, with two metallic sheets M1, M2, for example copper, arranged on cathode C.

Fig. 3B shows a side view of the cathode C where the support plate P (which acts as a cooling system), the Si PM pellet and one of the metallic sheets M1 are visible.

When using cathodes C with colouring metal sheets M1, M2 placed on the former, said sheets M1, M2 are preferably placed by means of mechanical attachment, ensuring the best possible contact between sheets M1, M2 and cathode C, availing of the attachment thereof to the cooling system P of the machine. Depending on the dimensions of sheets M1, M2, their geometry and positioning, a greater or lesser amount of colouring metal will be co-deposited in the process. The relation between the area of cathode C (for example, of silicon) and the sheets used, is preferably in the range [3% - 15%]. As already mentioned, an alternative to placing sheets M1, M2, is to use a cathode C containing certain parts of the pure metal to be co-deposited or to use a simultaneous deposition multi-target system.

The structure of interferential layers is deposited by sputtering a silicon cathode with argon, in the presence of oxygen, to obtain the anti-reflectant or mirror characteristics. The deposition conditions are argon flows between 1 and 50 sccm, with an alternated presence of oxygen or nitrogen between 3 sccm and 50 sccm and an electrical power between 500W and 3000W, giving rise to voltages between 300 V and 1000 V. The initial pressure was set at 2.0 10⁻⁶ mbar. The usual working pressures are in the range of [10⁻³ - 10⁻⁴] mbar.

In all the previous steps, the silicon cathode (also called white, or target) that is necessary to produce oxides or nitrides, can be replaced with an oxide cathode, such as for example (SiO₂, Ta₂O₅, etc.) multitarget. In this case, the contribution of oxygen to obtaining the suitable stechiometry is less and control of the process is better.

Finally, using high vacuum evaporation techniques with the joule effect or electron gun or dipping processes at atmospheric pressure, a layer with a hydrophobic function is deposited, preferably a perfluorated layer between 5 and 40 nm thick, which reduces the friction coefficient, thereby making it easier to clean the lens.

### Examples:

### a) Producing a green lens with colourmetric co-ordinates (0.331, 0.358, 0.311) according to CIE (x, y, z) 1931 on a previously lacquered MR7 lens and coated with an anti-reflectant multi-layer.

The lens lacquered with DN1600 lacquer, conveniently washed and desgasified during 2 hours at 80ºC is introduced into the sputtering machine. The vacuum is formed in the chamber of the sputtering machine, up to a value of 10⁻⁵ mbar. Then the activation process for the surface of the lacquered lens ensemble is carried out in high vacuum equipment by applying argon and oxygen plasma. Then, and without breaking the vacuum, a layer of SiO₂ is deposited by sputtering 10 sccm of argon on a pure silicon cathode and a strip of copper on the cathode placed as described above. A silicon cathode by the firm GENCOA- Kurk J. Lesker (Gencoa Part number PV00198) was used as the target. The copper strip used was supplied by GoodFellow (catalogue number Cu000652. Semi-hard copper at 99.9%). The dimensions of the copper strip used were: 1.4 mm wide and 0.25 mm thick. The position of the sheet on the cathode is described in Figure 1. The sputtering process is carried out in the presence of oxygen (10 sccm) at an electrical power of 300 W, giving rise to a voltage of about 520 V. The co-depositing process will last 2700 seconds under the conditions indicated, to provide a thickness of 1200 nm which produces the green colour shown in Figure 2. This way, a 39% Cu in front of (Si + Cu) content is obtained according to the results of the XPS analysis.

Then, without breaking the vacuum at any time until the end of the process, a layer of SiO₂ is deposited by sputtering 6 sccm of argon on a pure silicon cathode in the presence of oxygen (9 sccm) at an electrical power of 2200W, giving rise to a voltage of about 700 V.

On this adherence layer, a flexible layer is deposited which mixes the sputtering and radio frequency PeCVD processes, by introducing into the chamber during the sputtering process (of argon on the silicon cathode in the presence of oxygen) a volatile silicon precursor, preferably HMDSO. The dilutions of the three components, argon, oxygen and HMDSO will be as follows:
- 40 sccm of argon.
- 12 sccm of oxygen.
- 8 sccm of HMDSO.

The total pressure will ideally be 8'0x10⁻⁴ mbar and applying an electrical power of 1750W and a voltage of about 420 V.

The total thickness of this flexible layer has to be approximately 900 nm. It is possible to distribute this layer in order accommodate the stresses is various parts of the process.

Subsequently a hard layer of SiO₂ is deposited, approximately 530 nm thick by sputtering a silicon cathode with argon. The deposition conditions will be argon flow of 9 sccm, in the presence of oxygen of around 12 sccm and an electrical power of 1750W. The resulting voltage is 550 V.

Then the structure of interferential layers (preferably 4) is applied to build the interferential multi-layer deposited by sputtering a silicon cathode with argon, in the alternate presence of oxygen/nitrogen to obtain the anti-reflectant property. The deposition conditions are argon flows of 9 sccm, in the alternate presence of oxygen or nitrogen around 12 sccm and an electric power of 2000W in all cases. The voltages of the SiO₂ layers are 550 V and those of the Si₃N₄ layers are 450 V. The total thickness of the interferential multi-layer is 220 nm.

Thanks to the thickness of the polymerised layer with 900 nanometres of plasma in said depositing conditions, and of the SiO₂ layer that is 530 nm thick, an abrasion resistance for the whole ensemble of about BR=47 on the MR7 substrate is obtained.

Finally, using EBPVD, a layer with a hydrophobic function is deposited, preferably a perfluorated layer about 15 nm thick.

### TABLES:

(The flow values are in sccm)
1.- Lacqer activation conditions via high vacuum plasma

| function | duration (sees) | power (W) | voltage (V) | flow [Ar] | flow [02] | flow [N2] | flow [HMDSO] | pressure (mbar) |
|---|---|---|---|---|---|---|---|---|
| Activation | 50 | 300 | 200 | 20 | 20 | 0 | 0 | 6.0 10⁻⁴ |

2.- Depositing conditions of the adhesion layer via high vacuum

| function | thickness (nm) | power (W) | voltage (V) | flow [Ar] | flow [O2] | flow [N2] | flow [HMDSO] | pressure (mbar) |
|---|---|---|---|---|---|---|---|---|
| Adhesion | 4 | 2200 | 700 | 6 | 9 | 0 | 0 | 2.0 10⁻⁴ |

3.- Depositing conditions of the flexible layer via high vacuum PeCVD

| function | thickness (nm) | power (W) | voltage (V) | flow [Ar] | flow [O2] | flow [N2] | flow [HMDSO] | pressure (mbar) |
|---|---|---|---|---|---|---|---|---|
| Flexible | 900 | 1750 | 420 | 40 | 12 | 0 | 8 | 8.0 10⁻⁴ |

4.- Depositing conditions of the hard layer of SiO₂ thicker than 300nm

| function | thickness (nm) | power (W) | voltage (V) | flow [Ar] | flow [O2] | flow [N2] | flow [HMDSO] | pressure (mbar) |
|---|---|---|---|---|---|---|---|---|
| SiO₂ | 530 | 1750 | 550 | 9 | 12 | 0 | 0 | 2.0 10⁻⁴ |

5.- Depositing conditions of the interferential multi-layer done with high vacuum

| function | thickness (nm) | power (W) | voltage (V) | flow [Ar] | flow [O2] | flow [N2] | flow [HMDSO] | pressure (mbar) |
|---|---|---|---|---|---|---|---|---|
| SiO₂ | (2-220) | 1750 | 550 | 9 | 12 | 0 | 0 | 2.0 10⁻⁴ |
| Si₃N₄ | (2-150) | 2000 | 450 | 9 | 0 | 12 | 0 | 2.0 10⁻⁴ |

## Claims

1. Polymer based lens comprising a hardening layer (L) and an interferential multi-layer (I), where said hardening layer (L) is at least 500 nm thick and said interferential multi-layer (I) is made up of a plurality of sublayers where each of said sublayers is less than 250 nm thick, **characterized in that** it comprises, in addition, an absorbent layer (A) sandwiched between said hardening layer (L) and said interferential multi-layer (I), where said absorbent layer (A) is between 10 nm and 1500 nm thick and it is made from a material from the group made of those metals, metal oxides and metal nitrides that are suitable for producing a transparent layer in the visible spectrum via deposition by sputtering, where said absorbent layer (A) comprises, in addition, cations of a colouring metal from the group made up of those transition elements which, in oxided form, have a cation that absorbs electromagnetic radiation in the visible spectrum, where said colouring metal cations are in a proportion between 10% and 70% atomic percentage of the cations with respect to the cation of the predominant metal in said absorbent layer (A), except: [i] in the case where said absorbent layer is made from TiO2 and said colouring metal cations are Si cations, where said Si cations are in a proportion between 11.5% and 16.5% atomic percentage of the cations, [ii] in the case where the absorbent layer is made from SiO2 and the colouring metal cations are Mn cations, where the Mn cations are in a proportion between 37.5% y and 42.5% atomic percentage of the cations, [iii] in the case where the absorbent layer is made from SiO2 and the colouring metal cations are Cr cations, where the Cr cations are in a proporotion between 47.5% and 52.5% atomic percentage of the cations, and [iv] in the case where the absorbent layer is made from Cr2O3 and the colouring metal cations are Si cations, where the Si cations are in a proportion between 47.5% and 52.5% atomic percentage of the cations.

2. Lens according to claim 1, **characterized in that** said material from the group made up of: metals, metal oxides and metal nitrides suitable for producing a transparent layer in the visible spectrum via deposition by sputtering is a material from the group made up of: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic ytrium, Y₂O₃, magnesium, MgO, carbon, praseodimium, PrO₂, Pr₂O₃, tungsten, WO₃, silicon nitrides, silicon oxynitrides, and mixtures of the above.

3. Lens according to one of the claims 1 or 2, **characterized in that** said colouring metal is a metal from the group made up of Ni, Cu, Fe, Cr, V, W, Co, Mn, Si and mixtures of the above.

4. Lens according to any of the claims 1 to 3, **characterized in that** said absorbent layer (A) has visible transmittance between 4% and 85%.

5. Lens according to any of the claims 1 to 4, **characterized in that** said absorbent layer (A) has a plurality of different colouring metal cations.

6. Lens according to any of the claims 1 to 5, **characterized in that** it comprises a plurality of absorbent layers (A).

7. Lens according to any of the claims 1 to 6, **characterized in that** at least one of said absorbent layers (A) has different colouring metal cations than the other absorbent layers.

8. Lens according to any of the claims 1 to 7, **characterized in that** said absorbent layer (A) is between 100 nm and 600 nm thick.

9. Lens according to any of the claims 1 to 8, **characterized in that** said absorbent layer (A) is more than 300 nm thick.

10. Lens according to any of the claims 1 to 9, **characterized in that** it comprises, in addition, a hard layer (D) sandwiched between said hardening layer (L) and said absorbent layer (A), where said hard layer (D) is more than 300 nm thick and is made from a material from the group made up of : metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic ytrium, Y₂O₃, magnesium, MgO, carbon, praseodimium, PrO₂, Pr₂O₃, tungsten, WO₃, silicon nitrides, silicon oxynitrides, and **in that** said absorbent layer (A) can be obtained from polymerising volatile precursors of metals in the silicon family, zirconium family, titanium family and tantalum family, using a PECVD and/or sputtering method.

11. Method for manufacturing a polymer based lens according to claims 1 to 10, **characterized in that** it comprises a stage [a] of forming said hardening layer (L), a stage [b] of forming said absorbent layer (A), and a stage [c] of forming said interferential multi-layer (I), where said stage [b] is carried out by sputtering said material from the group made up of those metals, metal oxides and metal nitrides that are suitable for producing a transparent layer in the visible spectrum via deposition by sputtering, and said cations of said colouring metal from the group made up of those transition elements which, in oxided form, have a cation that absorbs electromagnetic radiation in the visible spectrum.

12. Method according to previous claim, **characterized in that** said sputtering stage [b] is carried out in an atmosphere comprising at least one of the components from the group made up of 02, N2, Ar, volatile precursors of metals in the silicon family, the zirconium family, the titanium family and the tantalum family.

13. Method according to one of the claims 11 or 12, **characterized in that** it comprises a stage [b2] of forming a second absorbent layer.

14. Method according to any of the claims 11 to 13, **characterized in that** said sputtering stage [b] comprises using an Si cathode where its surface has been partially coated with a sheet of one of said colouring metals.

15. Method according to claim 14, **characterized in that** between 3% and 15% of the surface of said cathode has been coated with said sheet.

16. Method according to one of the claims 14 or 15, **characterized in that** its surface has been partially coated with at least a second sheet of a second colouring metal.

17. Method according to any of the claims 11 to 16, **characterized in that** said sputtering stage [b] comprises using a cathode comprising Si and one of said colouring metals.

18. Method according to claim 17, **characterized in that** said cathode comprises, in addition, a second colouring metal.

19. Method according to any of the claims 11 to 18, **characterized in that** sputtering stage [b] comprises using various cathodes, where at least one of them comprises one of said colouring metals, in a simultaneous deposition process.

20. Method according to claim 19, **characterized in that** at least one of said cathodes comprises a second colouring metal.
